# EUROPÄISCHE PATENTANMELDUNG

(11) **EP 4 160 898 A1**
(43) Veröffentlichungstag der Anmeldung: **05.04.2023**
(21) Anmeldenummer: 22198223.4
(22) Anmeldetag: 28.09.2022
(51) Int. Cl.: H02M 7/00, H01L 25/07, H02G 5/00, H05K 7/20, H01R 12/58, H01R 13/11, H02M 7/48, B60K 7/00

(54) **INVERTER MIT OPTIMIERTEM ELEKTROMAGNETISCHEM VERHALTEN**

(30) Priorität: 30.09.2021 DE 102021210938
(71) Anmelder: ZF Friedrichshafen AG, 88046 Friedrichshafen (DE)
(72) Erfinder: Trenz, Ivonne, 88046 Friedrichshafen (DE); Kohr, Michael, 88285 Bodnegg (DE); Pahn, Florian, 88212 Ravensburg (DE); Wang, Pengshuai, 88097 Eriskirch (DE); Raimann, Manuel, 88682 Salem (DE); Rau, Philipp, 88045 Friedrichshafen (DE); Zeller, Jonas, 88045 Friedrichshafen (DE); Müller, Gerhard, 88090 Immenstaad am Bodensee (DE)

(57) **Zusammenfassung**

Die Erfindung betrifft einen Inverter (10) zum Betreiben eines elektrischen Antriebs in einem Elektrofahrzeug und/oder einem Hybridfahrzeug, umfassend einen DC-Eingang (12) zum Anschließen einer DC-Spannungsquelle, einen Zwischenkreiskondensator (14), der mehrere Eingangskontakte (142) zum Injizieren eines mittels der DC-Spannungsquelle erzeugten DC-Stroms aufweist, wobei die Eingangskontakte (142) an einem Kondensatorgehäuse (146) des Zwischenkreiskondensators (14) angebracht sind, mehrere Halbbrücken (16A-C), die jeweils mehrere Halbleiterschaltelemente zum Umwandeln des DC-Stroms in einen AC-Strom mit mehreren Phasenströmen aufweisen, wobei die Halbbrücken (16A-C) in einer Querrichtung des Inverters (10) in einer Reihe angeordnet sind, eine DC-Stromschienenanordnung zum Einspeisen des DC-Stroms in die Halbbrücken, die eine positive DC-Stromschiene (18) und eine negative DC-Stromschiene (20) aufweist, wobei sich die positive und/oder negative DC-Stromschiene (18, 20) in der Querrichtung des Inverters (10) über die Reihe der Halbbrücken (16A-C) erstreckt, sodass die Breite der positiven und/oder negativen DC-Stromschiene (18, 20) an die Breite der Reihe der Halbbrücken (16A-C) heranreicht, eine AC-Stromschienenanordnung (22) zum Abgeben des AC-Stroms in den elektrischen Antrieb, einen Kühler (24) zum Abkühlen der Halbbrücken (16A-C).

## Beschreibung

Die Erfindung betrifft einen Inverter zum Bestromen eines elektrischen Antriebs eines Elektrofahrzeugs oder eines Hybridfahrzeugs sowie ein entsprechendes Fahrzeug mit einem solchen Inverter.

Im Stand der Technik sind reine Elektrofahrzeuge sowie Hybridfahrzeuge bekannt, welche ausschließlich bzw. unterstützend von einer oder mehreren elektrischen Maschinen als Antriebsaggregate angetrieben werden. Um die elektrischen Maschinen solcher Elektrofahrzeuge bzw. Hybridfahrzeuge mit elektrischer Energie zu versorgen, umfassen die Elektrofahrzeuge und Hybridfahrzeuge elektrische Energiespeicher, insbesondere wiederaufladbare elektrische Batterien. Diese Batterien sind dabei als Gleichspannungsquellen ausgebildet, die elektrischen Maschinen benötigen in der Regel jedoch eine Wechselspannung. Daher wird zwischen einer Batterie und einer elektrischen Maschine eines Elektrofahrzeugs oder eines Hybridfahrzeugs üblicherweise eine Leistungselektronik mit einem sog. Inverter geschaltet.

Derartige Inverter umfassen üblicherweise Halbleiterschaltelemente, die typischerweise aus Transistoren gebildet sind. Dabei ist es bekannt, die Halbleiterschaltelemente in unterschiedlichen Integrationsgraden bereitzustellen, nämlich entweder als diskrete Einzelschalter mit einem geringen Integrationsgrad, jedoch hoher Skalierbarkeit, als Leistungsmodule mit einem hohen Integrationsgrad, jedoch geringer Skalierbarkeit, sowie als Halbbrücken, die hinsichtlich Integrationsgrad und Skalierbarkeit zwischen Einzelschaltern und Halbbrücken bzw. Leistungselektronikmodulen rangieren.

Die aus dem Stand der Technik bekannten Inverter weisen bauartbedingt eine hohe Streuinduktivität auf. Dadurch, dass die Streuinduktivität an die Schaltgeschwindigkeit der Halbleiterschaltelemente koppelt und hierdurch Spannungsüberhöhungen verursacht, ist die Funktionalität der bekannten Inverter beeinträchtigt. Außerdem ist die Wärme, die im Betrieb des Inverters erzeugt wird, nur unzureichend abführbar, was die Funktionalität des Inverters beeinträchtigt.

Es ist eine Aufgabe der Erfindung, einen Inverter bereitzustellen, um die vorstehend genannten Nachteile zumindest teilweise zu beheben.

Diese Aufgabe wird erfindungsgemäß durch den Inverter und das Fahrzeug gemäß den unabhängigen Patentansprüchen gelöst. Vorteilhafte Ausgestaltungen und Weiterbildungen der Erfindung gehen aus den abhängigen Patentansprüchen hervor.

Die Erfindung betrifft einen Inverter zum Betreiben eines elektrischen Achsantriebs in einem Elektrofahrzeug und/oder einem Hybridfahrzeug. Der Inverter umfasst einen DC-Eingang zum Anschließen einer DC-Spannungsquelle. Die DC-Spannungsquelle ist beispielsweise eine Batterie, insbesondere eine Hochvolt-Batterie (HV-Batterie), die eine DC-Spannung von 400V oder 800V bereitstellt. Diese DC-Spannung wird zwischen einem positiven Pol und einem negativen Pol des DC-Eingangs angelegt. Der Inverter umfasst einen Zwischenkreiskondensator, der mehrere Eingangskontakte zum Injizieren eines mittels der DC-Spannungsquelle erzeugten DC-Stroms aufweist. Die Eingangskontakte sind an einem Kondensatorgehäuse des Zwischenkreiskondensators angebracht. Die Eingangskontakte umfassen sowohl positive als auch negative Eingangskontakte. Die positiven Eingangskontakte sind an den positiven Pol des DC-Eingangs und somit an eine positive Elektrode der DC-Spannungsquelle angeschlossen. Die negativen Eingangskontakte sind an den negativen Pol des DC-Eingangs und somit an eine negative Elektrode der DC-Spannungsquelle angeschlossen.

Der Inverter umfasst außerdem mehrere Halbbrücken, die jeweils mehrere Halbleiterschaltelemente zum Umwandeln des DC-Stroms in einen AC-Strom mit mehreren Phasenströmen aufweisen. Jede Halbbrücke ist einer Phase bzw. einem Phasenstrom des AC-Stroms zugeordnet. Die Halbrücken erstrecken sich entlang einer Längsrichtung vom DC-Eingang zum AC-Ausgang. Gleichzeitig sind die einzelnen Halbbrücken entlang einer senkrecht zur Längsrichtung stehenden Querrichtung in einer Reihe angeordnet.

Jede Halbbrücke kann vorzugsweise ein einziges Halbbrückenmodul oder mehrere Halbbrückenmodule umfassen. Das Halbbrückenmodul im Sinne der vorliegenden Erfindung ist eine modular ausgelegte Brückenschaltung, die eine Modulhighside und eine Modullowside umfasst. Die Modulhighside und die Modullowside umfassen jeweils ein oder mehrere parallelgeschaltete Halbleiterschaltelemente. Im Fall, dass eine Halbbrücke mehrere Halbbrückenmodule umfasst, sind die Modulhighsides dieser Halbbrückenmodule zueinander parallelgeschaltet und bilden eine gemeinsame Highside der gesamten Halbbrücke, wobei die Modullowsides dieser Halbbrückenmodule ebenfalls zueinander parallelgeschaltet sind und eine gemeinsame Lowside der gesamten Halbbrücke bilden. Dies bedeutet, dass je nach gewünschter Fahrzeugleistung die durch die Halbbrücken jeweils tragbare Strommenge durch eine geeignete Wahl der Anzahl an Halbbrückenmodulen beliebig nach oben oder unten skalierbar ist.

Der Inverter umfasst ferner eine DC-Stromschienenanordnung zum Einspeisen des DC-Stroms in die Halbbrücken. Die DC-Stromschienenanordnung weist eine positive DC-Stromschiene und eine negative DC-Stromschiene auf. Der DC-Strom fließt von den Eingangskontakten des Zwischenkreiskondensators über Letzteren zur positiven und negativen DC-Stromschiene. Dort wird der DC-Strom in die jeweiligen Halbbrücken, vorzugsweise in die einzelnen Halbbrückenmodule, eingespeist.

Mittels Schaltens der Halbleiterschaltelemente der Halbbrücken werden die Phasenströme und somit der gesamte AC-Strom basierend auf dem eingespeisten DC-Strom erzeugt. Eine AC-Stromschienenanordnung ist im Inverter angeordnet, um den AC-Strom an den elektrischen Achsantrieb abzugeben. Die AC-Stromschienenanordnung umfasst hierzu mehrere AC-Stromschienen, die jeweils mehrere Eingangskontakte und einen Ausgangskontakt aufweisen. Die Eingangskontakte sind an AC-Leistungsanschlüsse der Halbbrücken angeschlossen, wobei der Ausgangskontakt mit der E-Maschine des elektrischen Achsantriebs, insbesondere mit deren Wicklung, verbunden ist. Die Ausgangskontakte der mehreren Phasen sind Teil des AC-Ausgangs des Inverters.

Der Inverter umfasst ferner einen Kühler zum Abkühlen der Halbbrücken. Im Betrieb des Inverters erzeugen aufgrund der hohen Ströme und Verluste eine große Menge an Wärme, die abgeführt werden muss. Der Kühler ist vorzugsweise unterseitig an die Halbbrücken, insbesondere an eine Metallschicht eines Substrats der jeweiligen Halbbrückenmodule, angebunden.

Erfindungsgemäß erstrecken sich die positive und/oder negative DC-Stromschiene über die Reihe der Halbbrücken. Dies bedeutet, dass die Breite der positiven und/oder negativen DC-Stromschiene an die Breite der Reihe der Halbbrücken heranreicht. Dies vergrößert die Fläche der DC-Stromschienen, sodass die Stromdichte des durch die DC-Stromschienen zu tragenden DC-Stroms reduziert ist. Dies verringert die Wärme, die durch den Strom in die Halbbrücken erzeugt wird. Außerdem ist ein bezüglich der Längsrichtung symmetrischer Stromfluss ermöglicht, sowie die Streuinduktivität des Inverters vermindert und das elektromagnetische Verhalten (EMV) des Inverters verbessert . Außerdem ist durch die großflächigen DC-Stromschienen ein flacher Aufbau des Inverters erzielbar, was eine kompaktere Bauform für den Inverter bedeutet.

Gemäß einer Ausführungsform weisen die positive DC-Stromschiene und die negative DC-Stromschiene ausgangsseitig mehrere Stromschienenabzweige zum Anschließen an einen DC-Leistungseingang der Halbbrückenmodule, wobei jeder Stromschienenabzweig einem der Halbbrückenmodule zugeordnet ist. Bei einer beispielhaften Halbbrücke bestehend aus zwei Halbbrückenmodulen sind daher zwei Stromschienenabzweige dieser Halbbrücke zugeordnet, wobei bei einem dreiphasigen AC-Strom der Inverter insgesamt sechs Stromschienenabzweige aufweist. Diese Maßnahme erleichtert eine verteilte Kontaktierung zwischen der DC-Stromschienenanordnung und den Halbbrücken. Im Allgemeinen kann der Inverter je nach Stromklasse auch mehr oder weniger Halbbrückenmodule bzw. Stromschienenabzweige haben.

Gemäß einer weiteren Ausführungsform ist die positive DC-Stromschiene und/oder die negative DC-Stromschiene außenseitig mit einem stromisolierenden Spritzgussmaterial umspritzt. Die Umspritzung der DC-Stromschienenanordnung dient sowohl zur Erhöhung der mechanischen Stabilität als auch zur Vergrößerung der Luft- und Kriechstrecken zwischen der positiven und der negativen DC-Stromschienen, um eine sichere Potentialtrennung zwischen ihnen zu gewährleisten.

Gemäß einer weiteren Ausführungsform umfasst die Umspritzung der positiven DC-Stromschiene und/oder der negativen DC-Stromschiene mehrere Befestigungsstellen für je ein Befestigungsmittel zum Fixieren der Umspritzung an einem Invertergehäuse, wobei die Anzahl der Befestigungsstellen der Anzahl der Halbbrücken entsprechen kann, wobei eine relative Position zwischen der Befestigungsstelle und der zugehörigen Halbbrücke für alle Halbbrücken gleich ist. Die Befestigungsstellen sind beispielsweise als Öffnungen ausgebildet, insbesondere als Durchgangsöffnungen, die sich vorzugsweise durch die Umspritzung, die positive und die negative DC-Stromschiene hindurcherstrecken. Das Befestigungsmittel ist vorzugsweise ein metallisches Befestigungsmittel wie Schraube. Dadurch, dass die relative Position zwischen der Befestigungsstelle und der zugehörigen Halbbrücke für alle Halbbrücken gleich ist, ist die Stromverteilung daher besonders gleichmäßig für alle (drei) Phasen. Dies erhöht die Symmetrie des Stromflusses bezüglich der Längsrichtung, was die Funktionalität des Inverters hinsichtlich EMV zusätzlich optimiert.

Gemäß einer weiteren Ausführungsform weist die Umspritzung der positiven DC-Stromschiene und/oder der negativen DC-Stromschiene mehrere Öffnungen zum Durchführen von Signalanschlüssen der Halbbrücken auf. Diese Maßnahme erleichtert die Kontaktierung der Signalanschlüsse an eine Leiterplatte des Inverters, die oberseitig der Umspritzung anzubringen ist. Alternativ können die Signalanschlüsse über den Trägerrahmen positioniert werden.

Gemäß einer weiteren Ausführungsform sind alle Signalanschlüsse der Halbbrücken mit der Leiterplatte mittels Lötens verbunden. Auf diese Weise lassen sich alle Signalanschlüsse beim Montieren mittels des gleichen Verbindungsverfahrens, nämlich Löten, mit der Leiterplatte verbunden werden. Dies erübrigt zusätzliche Verbindungsschritte, die aufgrund des Einsatzes mehrerer verschiedener Verbindungsmethoden erforderlich wären, und reduziert somit den Montageaufwand des Inverters. Alternativ können Pressfit-Pins als Signalanschlüsse verwendet werden.

Gemäß einer weiteren Ausführungsform ist ein Trägerrahmen zum Aufnehmen der Halbbrückenmodule zwischen einem Invertergehäuse und einer Leiterplatte angeordnet, wobei mehrere Signalanschlüsse der Halbbrücken vertikal durch den Trägerrahmen in Richtung einer Leiterplatte hindurchgeführt sind. Der Trägerrahmen erhöht die mechanische Stabilität der Signalanschlüsse und schützt diese vor Brüchen beim Verbinden mit der Leiterplatte. Gleichzeitig dient der Trägerrahmen zur Positionierung der Signalanschlüsse. Außerdem ermöglicht der Trägerrahmen eine formschlüssige oder eine kraftschlüssige Verbindung zwischen verschiedenen Bauteilen innerhalb des Inverters, was die Robustheit des Inverters erhöht. Ferner wird der Trägerrahmen zur Einhaltung der Luft- und Kriechstrecken eingesetzt.

Gemäß einer weiteren Ausführungsform ist ein Temperatursensor zwischen einer Leiterplatte und dem Kühler angeordnet, derart, dass der Temperatursensor unterseitig mittels einer Wärmeleitschicht auf dem Kühler oder den Halbbrückenmodulen fixiert ist, wobei sich zumindest eine Signalleitung des Temperatursensors durch den Trägerrahmen hindurch bis in die Leiterplatte erstreckt. Zum einen ist der Temperatursensor an den Kühler thermisch besser gekoppelt. Zum anderen stabilisiert der Trägerrahmen die Position des Temperatursensors und erhöht die Zuverlässigkeit der Temperaturmessung.

Gemäß einer weiteren Ausführungsform ist eine stromisolierende Wärmeleitfolie zwischen einem Invertergehäuse und dem DC-Eingang, der DC-Stromschienenanordnung und/oder der AC-Stromschienenanordnung angeordnet. Die Wärmeleitfolie verbessert die thermische Kopplung zwischen dem Invertergehäuse einerseits und dem DC-Eingang, der DC-Stromschienenanordnung und/oder der AC-Stromschienenanordnung andererseits. Dies erzielt eine wirksamere Wärmeabfuhr von den stromtragenden Komponenten des Inverters. Auch dient die Wärmeleitfolie zur Einhaltung der Luft- und Kriechstrecken und somit zur Potentialtrennung zwischen den mit Strom beaufschlagten Bauteilen des Inverters.

Die Erfindung betrifft weiterhin einen elektrischen Achsantrieb mit einem solchen Inverter sowie ein Fahrzeug mit einem solchen elektrischen Achsantrieb. Daraus ergeben sich die bereits im Zusammenhang mit dem erfindungsgemäßen Inverter beschriebenen Vorteile auch für den erfindungsgemäßen Inverter und das erfindungsgemäße Fahrzeug.

Nachfolgend wird die Erfindung anhand von in den Figuren dargestellten Ausführungsformen beispielhaft erläutert.

Es zeigen:
- Fig. 1: eine schematische Darstellung eines Inverters in Perspektivansicht;
- Fig. 2: eine schematische Darstellung eines DC-Eingangs des Inverters aus Fig. 1 in seitliche Schnittansicht;
- Fig. 3: eine schematische Darstellung eines Zwischenkondensators und einer DC-Stromschienenanordnung des Inverters aus Fig. 1 in einer Perspektivansicht;
- Fig. 4-5: eine weitere schematische Darstellung der DC-Stromschienenanordnung des Inverters aus Fig. 1 in einer Perspektivansicht;
- Fig. 6: eine weitere schematische Darstellung des Inverters aus Fig. 1 in einer Seitenansicht;
- Fig. 7: eine schematische Darstellung einer AC-Stromschienenanordnung des Inverters aus Fig. 1 in einer Seitenansicht;
- Fig. 8: eine schematische Darstellung eines an der AC-Stromschienenanordnung angebrachten Temperatursensors in einer Perspektivansicht.

Gleiche Gegenstände, Funktionseinheiten und vergleichbare Komponenten sind figurenübergreifend mit den gleichen Bezugszeichen bezeichnet. Diese Gegenstände, Funktionseinheiten und vergleichbaren Komponenten sind hinsichtlich ihrer technischen Merkmale identisch ausgeführt, sofern sich aus der Beschreibung nicht explizit oder implizit etwas anderes ergibt.

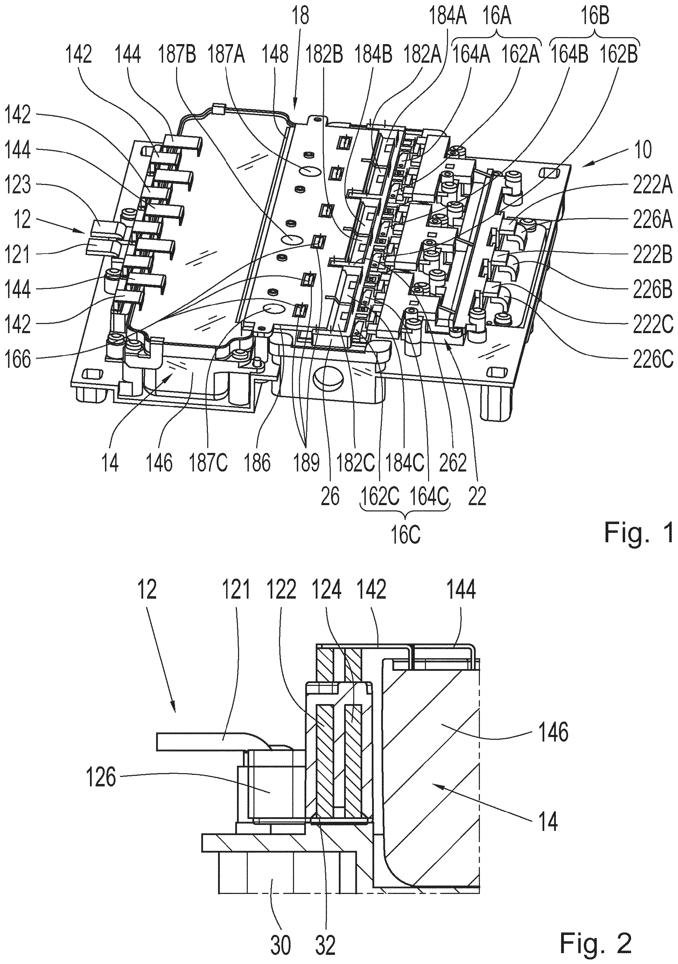

Fig. 1 zeigt eine schematische Darstellung eines Inverters 10 zum Bestromen eines elektrischen Achsantriebs in einem Elektrofahrzeug oder einem Hybridfahrzeug. Der Inverter 10 umfasst einen DC-Eingang 12, einen Zwischenkreiskondensator 14, mehrere Halbbrücken 16A-C, eine DC-Stromschienenanordnung, einen AC-Ausgang 22, einen Kühler 24, eine Leiterplatte 28 und ein Invertergehäuse 30. Zusätzlich weist der Inverter 10 weitere Komponenten, die unten ausführlich beschrieben sind.

Der DC-Eingang 12 ist hier und auch in Fig. 2 in einer seitlichen Schnittansicht näher gezeigt. Der DC-Eingang 12 umfasst einen positiven Eingangsanschluss 121 und einen negativen Eingangsanschluss 123, wobei die Eingangsanschlüsse 121, 123 zum Anschließen an eine DC-Spannungsquelle, vorzugsweise eine Batterie, insbesondere eine Hochvolt(HV)-Batterie, ausgebildet sind. Der DC-Eingang 12 umfasst ferner mehrere positive Eingangskontakte 122 und mehrere negative Eingangskontakte 124. Die positiven Eingangskontakte 122 sind hier als ausgangsseitige Stromkontakte des positiven Eingangsanschlusses 121 ausgebildet, wobei die negativen Eingangskontakte 124 als ausgangsseitige Stromkontakte des negativen Eingangsanschlusses 123 ausgebildet sind. Zwecks Potentialtrennung zwischen den positiven Eingangskontakten 122 und den negativen Eingangskontakten 124 sind die Eingangskontakte 122, 124 mit einem elektrisch isolierenden Spritzgussmaterial umspritzt. Die Umspritzung 126 dient gleichzeitig als Rahmen für die Eingangskontakte 122, 124 und ist unterseitig mittels einer stromisolierenden Wärmeleitfolie 32 auf dem Invertergehäuse 30 aufgebracht.

Der Zwischenkreiskondensator 14 umfasst ein Kondensatorgehäuse 146, auf dessen dem DC-Eingang 12 zugewandten ersten Rand mehrere positive und negative Kondensatoreingangskontakte 142, 144 angeordnet sind. Die positiven Kondensatoreingangskontakte 142 sind mit den positiven Eingangskontakten 122 elektrisch verbunden, wobei die negativen Kondensatoreingangskontakte 144 sind mit den negativen Eingangskontakten 124 elektrisch verbunden sind. Die Eingangskontakte 122, 124 und die Kondensatoreingangskontakte 142, 144 sind derart am Kondensatorgehäuse 146 angeordnet, dass die positiven Kondensatoreingangskontakte 142 und die negativen Kondensatoreingangskontakte 144 abwechselnd aneinandergereiht sind, wie in Fig. 1 gezeigt. Das Kondensatorgehäuse 146 ist kastenförmig ausgebildet und erstreckt sich in einer Längsrichtung zwischen dem DC-Eingang und dem AC-Ausgang sowie in einer dazu senkrechten Querrichtung.

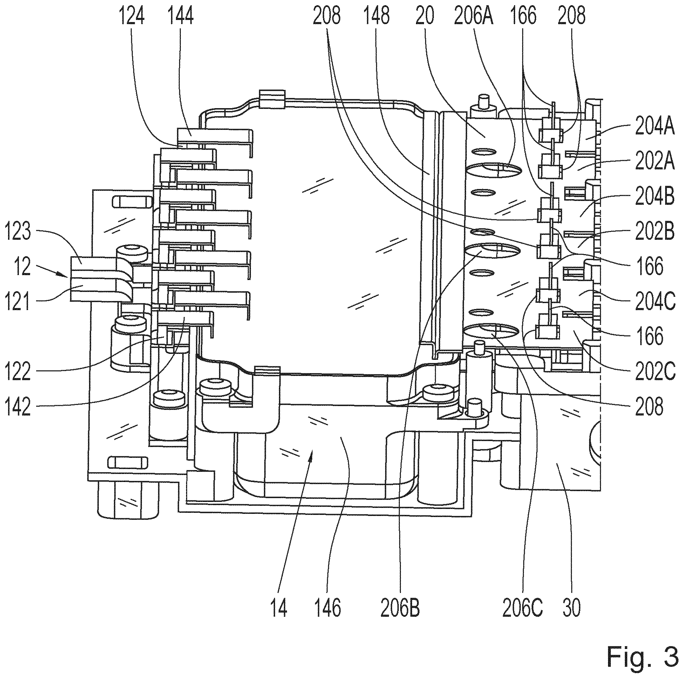

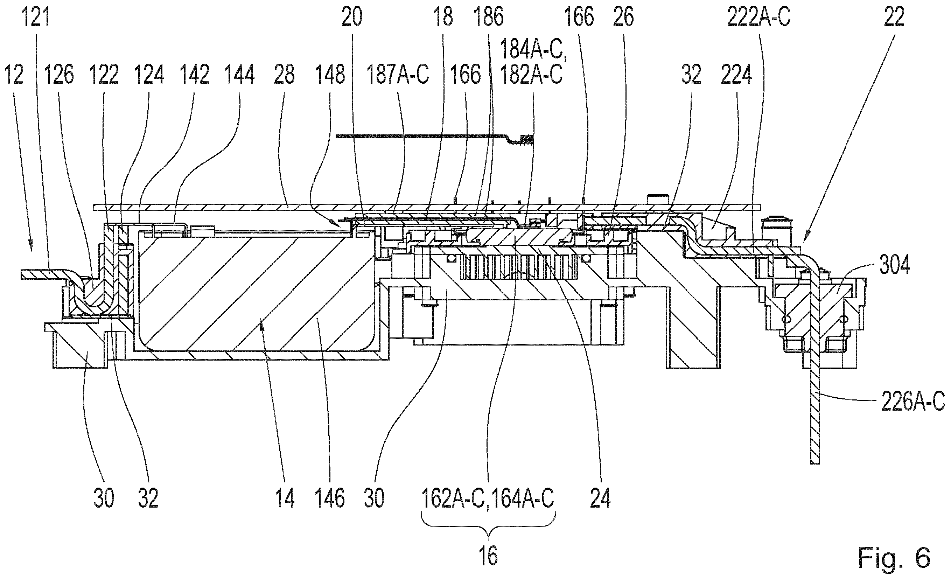

Die DC-Stromschienenanordnung ist an einem den Kondensatoreingangskontakten 142, 144 gegenüberliegenden zweiten Rand angebracht. Die DC-Stromschienenanordnung verbindet den Zwischenkreiskondensator 14 mit den Halbbrücken 16A-C. Dazu weist die DC-Stromschienenanordnung eine positive DC-Stromschiene 18 und eine negative DC-Stromschiene 20 auf, die sich über die Breite des Kondensatorgehäuses 146 erstrecken. Der Zwischenkreiskondensator 14 weist ausgangsseitig einen Querkontakt 148 auf (siehe Fig. 1, 3 und 6), mit dem die positive DC-Stromschiene 18 elektrisch verbunden ist, wie in der Seitenansicht in Fig. 6 gezeigt. Die negative DC-Stromschiene 20 ist dagegen im Zwischenkreiskondensator 14 integriert und erstreckt sich vorzugsweise, wie in Fig. 6 schematisch gezeigt, von der Leistungselektronik 16 bis in den Zwischenkreiskondensator 14 hinein. Die DC-Stromschienen 18, 20 weisen ausgangsseitig mehrere positive bzw. negative Stromschienenabzweige 182A-C, 184A-C, 202A-C, 204A-C auf, die jeweils mit einem Halbbrückenmodul 162A-C, 164A-C der Halbbrücken 16A-C verbunden sind. Die Halbbrückenmodule 162A-C, 164A-C umfassen jeweils eine Modulhighside und eine Modullowside, wobei die Modulhighside und die Modullowside jeweils ein oder mehrere parallelgeschaltete Halbleiterschaltelemente umfassen. In jeder Halbbrücke 16A-C sind die Modulhighsides der Halbbrückenmodule 162A-C, 164A-C zueinander parallelgeschaltet, um eine Highside der Halbbrücke 16A-C zu bilden. In jeder Halbbrücke 16A-C sind die Modullowsides der Halbbrückenmodule 162A-C, 164A-C zueinander parallelgeschaltet, um eine Lowside der Halbbrücke 16A-C zu bilden. Im hier gezeigten Beispiel umfasst jede Halbbrücke 16A-C ein erstes Halbbrückenmodul 162A-C und ein zweites Halbbrückenmodul 164A-C. Jedes Halbbrückenmodul 162A-C, 164A-C weist einen positiven DC-Leistungsanschluss und einen negativen DC-Leistungsanschluss auf. Mit dem positiven DC-Leistungsanschluss ist ein positiver Stromschienenabzweig 182A-C, 184A-C elektrisch kontaktiert. Mit dem negativen DC-Leistungsanschluss ist ein negativer Stromschienenabzweig 202A-C, 204A-C elektrisch kontaktiert. Die elektrische Kontaktierung erfolgt, wie in Fig. 6 schematisch gezeigt, oberseitig der jeweiligen Halbbrückenmodule 162A-C, 164A-C, was gegenüber herkömmlichen Kontaktierungsweisen einfacher ist und eine kompakte Bauform des Inverters 10 ermöglicht.

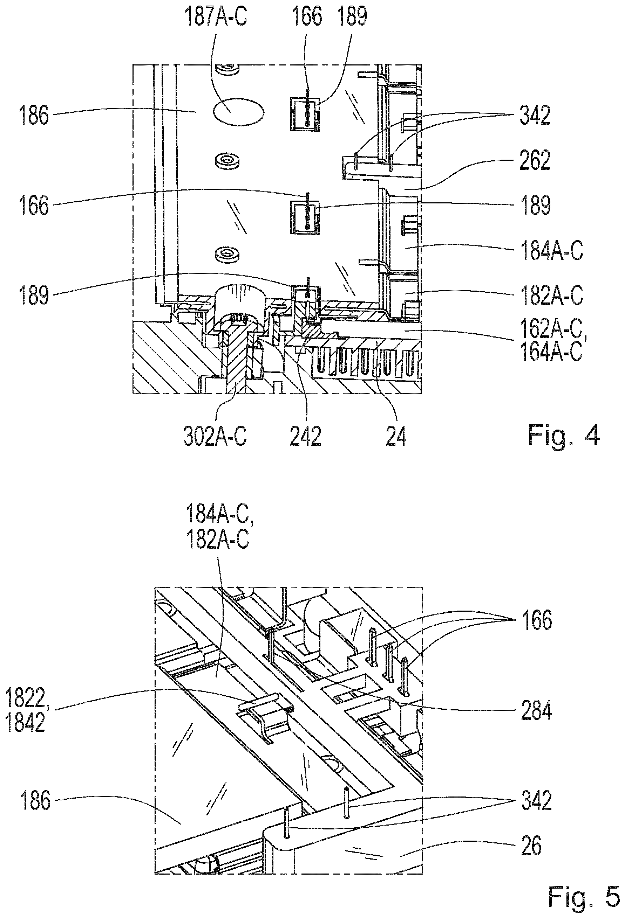

Die DC-Stromschienenanordnung kann ebenfalls mittels eines elektrisch isolierenden Spritzgussmaterial umspritzt werden. Im hier gezeigten Beispiel erfolgt die Umspritzung 186 der positiven DC-Stromschiene 18 beidseitig, d.h. oberseitig und unterseitig. Zwischen der Umspritzung 186 der positiven DC-Stromschiene 18 und der negativen DC-Stromschiene 20 ist eine Isolationsfolie vorgesehen, die sich vorzugsweise nur teilweise über der negativen DC-Stromschiene 18 erstreckt. Im Bereich zwischen dem Querkontakt 148 und den Stromschienenabzweigen 182A-C, 184A-C, 202A-C, 204A-C weisen die DC-Stromschienen 18, 20 jeweils einen entlang der Breite durchgehenden Zwischenabschnitt auf, in dem mehrere Befestigungsstellen 187A-C, 206A-C zum Anbringen mehrerer Befestigungsmittel 302A-C (siehe Fig. 4) zwecks Fixieren der DC-Stromschienenanordnung am Invertergehäuse 30 ausgebildet sind. Die Befestigungsstellen 187A-C, 206A-C sind vorzugsweise als Schraubenlöcher ausgebildet, wobei die Befestigungsmittel 302A-C vorzugsweise Schrauben sind, die oberseitig der DC-Stromschienenanordnung durch die positive DC-Stromschiene 18, die negative DC-Stromschiene 20 sowie die Umspritzung 186 bis ins Invertergehäuse 30 hineinreicht. Dies ermöglicht eine besonders stabile Befestigung der DC-Stromschienenanordnung. Zusätzlich sind mehrere Öffnungen 189, 208 im Zwischenabschnitt der positiven und negativen DC-Stromschienen 18, 20 ausgebildet, durch die mehrere Signalanschlüsse 166 der Halbbrücken 16A-C nach oben hindurchgeführt sind. Die Signalanschlüsse 166 erstrecken sich bis durch die Leiterplatte 28 hindurch, um Steuersignale zwischen dieser und den Halbbrücken 16A-C, insbesondere den Steueranschlüssen (Gate-Elektroden) der Halbleiterschaltelemente, zu übertragen.

Ein Trägerrahmen 26 ist, wie in Fig. 1 und 6 gezeigt, zwischen den Halbbrücken 16A-C einerseits und dem Invertergehäuse 30 andererseits angeordnet. Die Signalanschlüsse 166 erstrecken sich von den Halbleiterschaltelementen nach oben durch mehrere turmförmige Signalführungen des Trägerrahmens 26 sowie die Öffnungen 189, 208 der DC-Stromschienen 18, 20 hindurch, um in der Leiterplatte 28 aufgenommen zu werden (siehe Fig. 6). Unterseitig ist der Trägerrahmen 26 zum einen auf dem Kühler 24, zum anderen auf dem Invertergehäuse 30 gestützt. Der Kühler 24 kann, wie hier beispielhaft gezeigt, eine Kühlstruktur für eine direkt gekühlte Flüssigkeitskühlung mit mehreren Finnen (Pin-Fin-Struktur) aufweisen, die sich von einer Kühlplatte ausgehend nach unten erstrecken. Diese Kühlstruktur kann geometrisch auf verschiedene Randbedingungen ausgelegt werden, sodass ein optimales Verhältnis zwischen eingesetzter Strömungsenergie und abzuführender Wärmeleistung hergestellt wird. Dies vergrößert die Kühlfläche und erhöht die Kühlleistung.

Die Halbbrückenmodule 162A-C, 164A-C sind außen mit einer Umspritzung aus einem elektrischen isolierenden Spritzgussmaterial versehen, um die Halbleiterschaltelemente vor Umgebungseinflüssen zu schützen. Nur die Leistungsanschlüsse (nicht gezeigt), die Signalanschlüsse 166 und eine an den Kühlkörper 24 anbindende Unterfläche sind vom Spritzgussmaterial freigelegt. Die Halbbrückenmodule 162A-C, 164A-C sind jeweils mittels Sinterns oder Lötens mit der Kühlplatte verbunden. Der Trägerrahmen 26 dient zur Führung der Signalanschlüsse 166, Aufnahme eine (unten näher beschriebenen) Temperatursensors 34 und zur Einhaltung der Luft- und Kriechstrecken. Eine Isolierfolie 242 ist zwischen den Halbbrückenmodulen 182A-C, 184A-C und dem Kühler 24 angeordnet, um die Luft- und Kriechstrecken zwischen den Leistungsanschlüssen der Halbbrückenmodule 162AC, 164A-C einerseits und der Kühlplatte andererseits einzuhalten.

Der AC-Ausgang 22 (bzw. die AC-Stromschienenanordnung) umfasst mehrere AC-Stromschienen 222A-C, mehrere mit den AC-Stromscheinen 222A-C verbundene AC-Ausgangskontakte 226A-C sowie eine Umspritzung 224, die durch Aufspritzen der AC-Stromschienen 222A-C mit einem elektrisch isolierenden Spritzgussmaterial entsteht. In diesem Beispiel erfolgt die Umspritzung 224 oberseitig der AC-Stromschienen 222A-C. Unterseitig der AC-Stromschienen 222A-C ist eine stromisolierende Wärmeleitfolie 32 zwecks erhöhter thermischer Kopplung zum Invertergehäuse 30 angeordnet. Auf der Unterseite sind die AC-Stromschienen 222A-C teils mit der stromisolierenden Wärmeleitfolie 32 und teils mit einem elektrisch isolierenden Material umspritzt. Diese Maßnahme gewährleistet eine lokale thermische Kopplung dort, die auf einen Bereich eingeschränkt wird, in dem eine unterseitige Kühlung der AC-Stromschienen 222A-C benötigt wird. Hierdurch wird vermieden, dass die kostenintensive stromisolierende Wärmeleitfolie 32 unnötigerweise eingesetzt wird. Die AC-Stromscheinen 222A-C erstrecken sich jeweils horizontal zwischen einem AC-Leistungsanschluss der Halbbrückenmodule 162A-C, 164A-C und einem der AC-Ausgangskontakte 226A-C. Die Halbbrückenmodule 162A-C, 164A-C weisen jeweils mehrere (in diesem Beispiel zwei) AC-Leistungsanschlüsse auf, die jeweils mit einer der AC-Stromschienen 222A-C elektrisch verbunden sind. Die AC-Ausgangskontakte 226A-C sind vertikal ausgerichtet und schauen über einen Endabschnitt 304 des Invertergehäuses 30 hinaus, um an Wicklungen einer E-Maschine des elektrischen Achsantriebs angebunden zu werden.

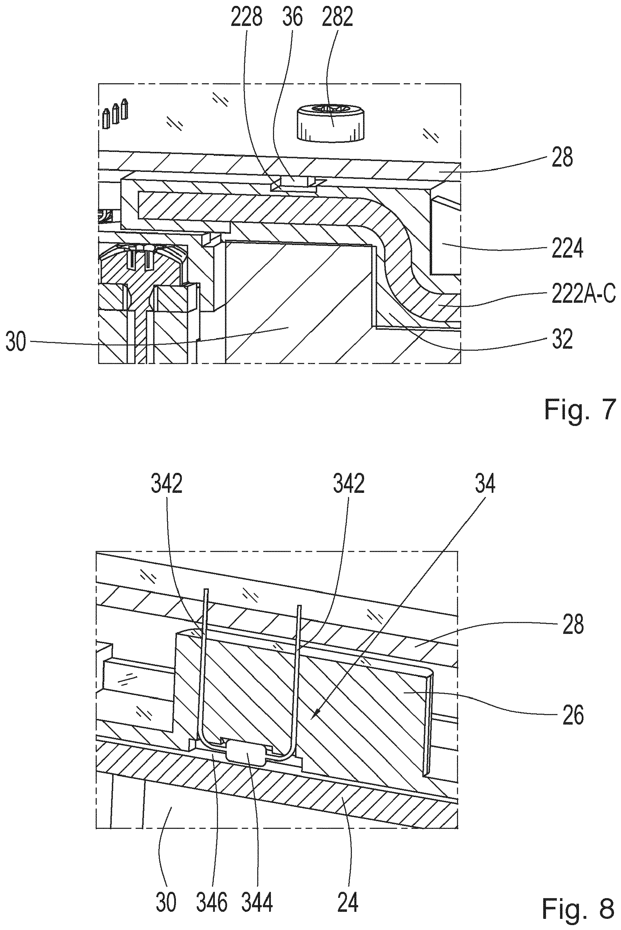

Wie in Fig. 7 gezeigt, ist ein Stromsensor 36 unterseitig der Leiterplatte 28 mit dieser elektrisch verbunden, vorzugsweise verlötet. Unterhalb des Stromsensors 36 ist eine Aussparung 228 in der Umspritzung 224 der AC-Stromschienen 222A-C ausgebildet. Die Aussparung 228 verkleinert den Abstand zwischen dem Stromsensor 36 und den AC-Stromschienen 222A-C. Zugleich dient eine Bodenschicht der Aussparung 228 zur Potentialtrennung zwischen dem Stromsensor 36 und den AC-Stromschienen 222A-C. Der Stromsensor 36 wird verwendet, um die jeweiligen AC-Phasenströme zu erfassen. Der Stromsensor 36 umfasst typischerweise mehrere Signalleitungen (hier nicht gezeigt), die elektrisch mit der Leiterplatte 28 verbunden bzw. verlötet sind, um die erfassten Stromstärken an eine interne oder externe Prozessiereinheit, etwa eine ECU des Fahrzeugs (hier nicht gezeigt), zu übertragen.

Ein Temperatursensor 34 ist, wie in Fig 8 gezeigt, in einem Zwischenraum zwischen dem Trägerrahmen 26 und dem Kühler 24 angeordnet. Der Temperatursensor 34 umfasst einen Sensorkörper 344 und zwei Signalleitungen 342, die sich von beiden Enden des Sensorkörpers 344 heraus zunächst horizontal, anschließend vertikal nach oben erstrecken. Hierbei sind die Signalleitungen 342 durch den Trägerrahmen 26 und die Leiterplatte 28 hindurchgeführt. Eine Wärmeleitschicht 346 ist zwischen dem Sensorkörper 344 und dem Kühler 24 angebracht.

### Bezugszeichen

10 Inverter
12 DC-Eingang
121 negativer Eingangsanschluss
122 negative Eingangskontakte
123 positiver Eingangsanschluss
124 positive Eingangskontakte
126 Umspritzung
14 Zwischenkreiskondensator
142 positive Kondensatoreingangskontakte
144 negative Kondensatoreingangskontakte
146 Kondensatorgehäuse
148 Kondensatorausgang
16A-C Halbbrücken
162A-C, 164A-C Halbbrückenmodule
166 Signalanschlüsse
18 positive DC-Stromschiene
182A-C, 184A-C positive Stromschienenabzweige
1822, 1842 Laserschweißung
186 Umspritzung
187A-C Befestigungsstellen
188 Querkontakt
189 Öffnungen
20 negative DC-Stromschiene
202A-C, 204A-C negative Stromschienenabzweige
206A-C Befestigungsstellen
208 Öffnungen
22 AC-Ausgang
222A-C AC-Stromschienen
224 Umspritzung
226A-C Ausgangsanschlüsse
228 Aussparung
24 Kühler
242 Isolationsfolie
26 Trägerrahmen
262 Barriere
28 Leiterplatte
282 Schraube
284 Kontaktierung
30 Invertergehäuse
302A-C Schrauben
304 Endabschnitt
32 Wärmeleitfolie
34 Temperatursensor
342 Signalleitung
344 Sensorkörper
346 Wärmeleitschicht
36 Stromsensor

## Patentansprüche

1. Inverter (10) zum Betreiben eines elektrischen Antriebs in einem Elektrofahrzeug und/oder einem Hybridfahrzeug, umfassend:
- einen DC-Eingang (12) zum Anschließen einer DC-Spannungsquelle,
- einen Zwischenkreiskondensator (14), der mehrere Eingangskontakte (142) zum Injizieren eines mittels der DC-Spannungsquelle erzeugten DC-Stroms aufweist, wobei die Eingangskontakte (142) an einem Kondensatorgehäuse (146) des Zwischenkreiskondensators (14) angebracht sind,
- mehrere Halbbrücken (16A-C), die jeweils mehrere Halbleiterschaltelemente zum Umwandeln des DC-Stroms in einen AC-Strom mit mehreren Phasenströmen aufweisen, wobei die Halbbrücken (16A-C) in einer Querrichtung des Inverters (10) in einer Reihe angeordnet sind,
- eine DC-Stromschienenanordnung zum Einspeisen des DC-Stroms in die Halbbrücken, die eine positive DC-Stromschiene (18) und eine negative DC-Stromschiene (20) aufweist, wobei sich die positive und/oder negative DC-Stromschiene (18, 20) in der Querrichtung des Inverters (10) über die Reihe der Halbbrücken (16A-C) erstreckt, sodass die Breite der positiven und/oder negativen DC-Stromschiene (18, 20) an die Breite der Reihe der Halbbrücken (16A-C) heranreicht,
- eine AC-Stromschienenanordnung (22) zum Abgeben des AC-Stroms in den elektrischen Antrieb,
- einen Kühler (24) zum Abkühlen der Halbbrücken (16A-C).

2. Inverter (10) nach Anspruch 1, wobei die Halbbrücken (16A-C) jeweils mehrere Halbbrückenmodule (162A-C, 164A-C) umfassen, die jeweils eine Modulhighside und eine Modullowside aufweisen, wobei die Modulhighside und die Modullowside jeweils ein oder mehrere parallelgeschaltete Halbleiterschaltelemente umfassen, wobei in jeder Halbbrücke die Modulhighsides der Halbbrückenmodule (162A-C, 164A-C) zueinander parallelgeschaltet sind, um eine Highside der Halbbrücke zu bilden, wobei in jeder Halbbrücke (16A-C) die Modullowsides der Halbbrückenmodule (162A-C, 164A-C) zueinander parallelgeschaltet sind, um eine Lowside der Halbbrücke (16A-C) zu bilden.

3. Inverter (10) nach Anspruch 2, wobei die positive DC-Stromschiene (18) und die negative DC-Stromschiene (20) ausgangsseitig mehrere Stromschienenabzweige (182A-C, 184A-C) zum Anschließen an einen DC-Leistungseingang der Halbbrückenmodule (162A-C, 164A-C) aufweisen, wobei jeder Stromschienenabzweig (182A-C, 184A-C) einem der Halbbrückenmodule (162A-C, 164A-C) zugeordnet ist.

4. Inverter (10) nach Anspruch 2 oder 3, wobei die positive DC-Stromschiene (18) und/oder die negative DC-Stromschiene (20) außenseitig mit einem stromisolierenden Spritzgussmaterial umspritzt ist.

5. Inverter (10) nach Anspruch 4, wobei die Umspritzung (186) der positiven DC-Stromschiene (18) und/oder der negativen DC-Stromschiene (20) mehrere Befestigungsstellen (187A-C) für je ein Befestigungsmittel zum Fixieren der Umspritzung (186) an einem Invertergehäuse (30) umfasst, wobei eine relative Position zwischen der Befestigungsstelle (187A-C) und der zugehörigen Halbbrücke (16A-C) für alle Halbbrücken (16A-C) gleich ist.

6. Inverter (10) nach Anspruch 5, wobei die Umspritzung (186) der positiven DC-Stromschiene (18) und/oder der negativen DC-Stromschiene (20) mehrere Öffnungen (189) zum Durchführen von Signalanschlüssen (166) der Halbbrücken (16A-C) aufweist.

7. Inverter (10) nach einem der Ansprüche 1 bis 6, wobei alle Signalanschlüsse (166) der Halbbrücken (16A-C) mit einer Leiterplatte (28) mittels Lötens verbunden oder als Pressfit-Pins ausgebildet sind.

8. Inverter (10) nach einem der Ansprüche 1 bis 7, wobei ein Trägerrahmen (26) zwischen einem Invertergehäuse (30) und einer Leiterplatte (28) angeordnet ist, wobei mehrere Signalanschlüsse (166) der Halbbrücken (16A-C) vertikal durch den Trägerrahmen (26) in Richtung einer Leiterplatte (28) hindurchgeführt sind.

9. Inverter (10) nach Anspruch 8, wobei ein Temperatursensor (34) zwischen einer Leiterplatte (28) und dem Kühler (24) angeordnet ist, derart, dass der Temperatursensor (34) unterseitig mittels einer Wärmeleitschicht (346) auf dem Kühler (24) fixiert ist, wobei sich zumindest eine Signalleitung (342) des Temperatursensors (34) durch den Trägerrahmen (26) hindurch bis in die Leiterplatte (28) erstreckt.

10. Inverter (10) nach einem der Ansprüche 1 bis 9, wobei eine Isolationsfolie (32) zwischen einem Invertergehäuse (30) und dem DC-Eingang (12), der DC-Stromschienenanordnung und/oder der AC-Stromschienenanordnung (22) angeordnet ist.

11. Elektrischer Achsantrieb für ein Fahrzeug, insbesondere ein Elektrofahrzeug oder Hybridfahrzeug, umfassend eine E-Maschine, eine Getriebeeinrichtung und einen Inverter (10) nach einem der Ansprüche 1 bis 10.

12. Fahrzeug, insbesondere Elektrofahrzeug oder Hybridfahrzeug, umfassend einen elektrischen Achsantrieb nach Anspruch 11.
